Europäisches Patentamt

(19) European Patent Office

Office européen des brevets

(11) Numéro de publication: **0 038 259**
**B1**

(12) **FASCICULE DE BREVET EUROPEEN**

(45) Date de publication du fascicule du brevet:
**15.02.84**

(21) Numéro de dépôt: **81400572.4**

(22) Date de dépôt: **10.04.81**

(51) Int. Cl.³: **G 01 R 31/02,** G 01 R 27/16,
G 01 R 29/16

---

(54) **Procédé d'identification de phases en défaut dans un réseau de distribution électrique.**

---

(30) Priorité: **15.04.80 FR 8008428**

(43) Date de publication de la demande:
**21.10.81 Bulletin 81/42**

(45) Mention de la délivrance du brevet:
**15.02.84 Bulletin 84/7**

(84) Etats contractants désignés:
**CH DE GB LI SE**

(56) Documents cités:
**FR - A - 1 597 420**
**FR - A - 2 206 507**

(73) Titulaire: **ENERTEC, 12 Place des Etats Unis,
F-92120 Montrouge (FR)**

(72) Inventeur: **Loewenstein, Paul, 5 Rue de Nesle,
F-75006 Paris (FR)**

(74) Mandataire: **Bentz, Jean-Paul, GIERS SCHLUMBERGER
Service BREVETS 12, place des Etats-Unis,
F-92124 Montrouge Cedex (FR)**

---

ACTORUM AG

# Procédé d'identification de phases en défaut dans un réseau de distribution électrique

La présente invention est relative à un procédé d'identification des phases en défaut d'un réseau de distribution d'énergie électrique.

Les perturbations électriques sur les réseaux de distribution d'électricité en courant alternatif peuvent survenir pour diverses raisons, telles que la mise en ou hors circuit de générateurs et de charges, ou l'apparition de défauts (par exemple court-circuit à la terre ou entre phases). La détection de ces perturbations fournit un moyen important pour détecter les défauts afin qu'une action (par exemple l'isolement d'une ligne ou d'un autre équipement en défaut) soit prise pour y remédier, mais il est naturellement nécessaire de distinguer les perturbations dues à des défauts de celles dues à des opérations de routine sur le réseau si on veut éviter des actions intempestives. De plus, comme le réseau peut subir de sérieux dommages si on laisse un défaut se prolonger même pour quelques millisecondes, il est souhaitable que l'équipement de détection et d'isolement des défauts agisse très rapidement.

Dans le cas particulier des réseaux triphasés, on peut distinguer habituellement deux types différents de défauts: le premier type concerne une mise à la terre accidentelle de l'une des phases, alors que le second type comprend tous les autres cas possibles de défauts, tels qu'un court-circuit accidentel entre phases.

Il se peut que le premier type de défaut ne soit que passager, provoqué par exemple par l'humidité sur un isolant. Dans ce cas, cela vaut la peine d'isoler initialement momentanément la phase en défaut pour laisser le temps au défaut de se dissiper éventuellement de lui-même, et un isolement des trois phases est seulement nécessaire si le défaut persiste.

Le brevet FR-A No 1597420 propose un procédé d'identification de phases en défaut dans un réseau triphasé de distribution électrique, procédé qui est basé sur la détermination des déphasages entre paramètres électriques relatifs au réseau triphasé considéré.

L'identification d'une phase en défaut est obtenue selon l'invention au moyen du procédé conforme à la revendication 1.

On va maintenant décrire un appareil pour la mise en œuvre du procédé selon l'invention en relation avec les dessins annexés donnés à titre d'exemples non limitatifs. Sur ces dessins:

la fig. 1 est un schéma synoptique de l'appareil;

la fig. 2 est un diagramme isométrique d'un espace tridimensionnel dont les axes correspondent aux axes respectifs des trois phases du réseau de distribution, indiquant en particulier la direction du vecteur homopolaire, et

la fig. 3 est un diagramme montrant des vecteurs dans un plan $\beta$ qui est orthogonal à l'axe homopolaire représenté fig. 2.

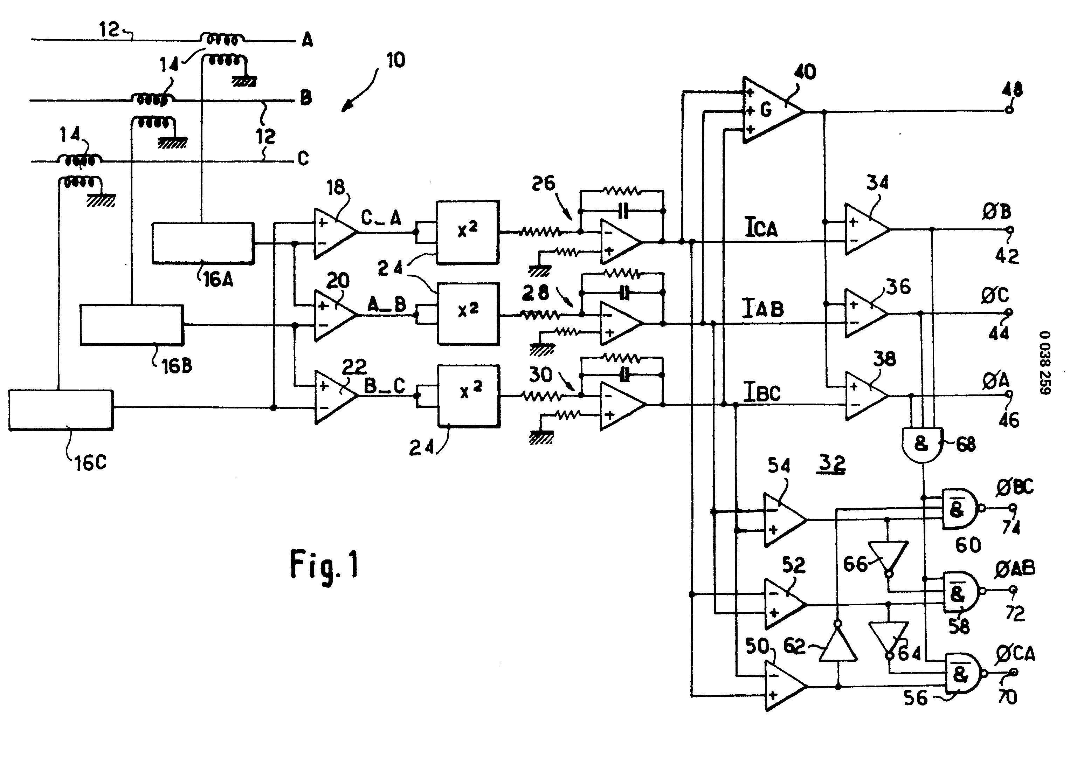

L'appareil qui va être décrit et qui est représenté fig. 1 est destiné à être utilisé sur une ligne de puissance triphasée, dans laquelle chaque phase est parcourue par du courant alternatif, à une fréquence industrielle par exemple de 50 ou 60 Hz, décalé d'un angle de phase de 120° par rapport à celui des autres phases.

En se reportant à la fig. 1, une ligne de puissance 10 a trois conducteurs 12 relatifs aux trois phases A, B et C. Sur chaque phase, il y a un transducteur de courant respectif 14, tel qu'un transformateur de courant, qui fournit un signal de tension de sortie représentatif de l'amplitude instantanée et de la polarité du courant dans le conducteur 12 correspondant.

Les signaux de sortie des transducteurs 14 sont appliqués sur des filtres respectifs 16. La nature de ces filtres dépend des circonstances particulières d'emploi de l'appareil, mais leur but est, dans tous les cas, de bloquer le passage de toute composante des signaux d'entrée dans les filtres qui est représentative des courants mesurés par les transducteurs 14 sur la ligne 10 pendant le fonctionnement normal exempt de défauts ou d'autres sources de perturbations. Les filtres 16 peuvent être par exemple des filtres à bande d'arrêt accordés pour rejeter la fréquence industrielle; en variante, ils pourraient être prévus pour mémoriser et comparer de brefs échantillons successifs des formes d'ondes du signal de courant, comme décrit dans le brevet DE-A No 2805524. Dans tous les cas, les signaux de sortie des filtres 16 sont représentatifs uniquement des courants transitoires apparaissant dans la ligne 10 à la suite de défauts, d'opérations de commutations ou d'autres sources de perturbations électriques.

Ces signaux de sortie sont appliqués aux entrées de trois amplificateurs différentiels 18, 20 et 22 par paires respectives comme suit: l'amplificateur différentiel 18 reçoit le signal de sortie du filtre 16A (couplé à la phase A) sur son entrée inverseuse et le signal de sortie du filtre 16C (couplé à la phase C) sur son entrée non inverseuse; l'amplificateur différentiel 20 reçoit le signal de sortie du filtre 16B (couplé à la phase B) sur son entrée inverseuse et le signal de sortie du filtre 16A sur son entrée non inverseuse, et l'amplificateur différentiel 22 reçoit le signal de sortie du filtre 16C sur son entrée inverseuse et le signal de sortie du filtre 16B sur son entrée non inverseuse.

Ainsi, l'amplificateur différentiel 18 forme le signal différentiel $C-A$; l'amplificateur différentiel 20 forme le signal différentiel $A-B$, et l'amplificateur différentiel 22 forme le signal différentiel $B-C$.

Ces trois signaux différentiels sont appliqués sur des circuits respectifs d'élévation au carré 24 qui sont à leur tour reliés aux entrées d'intégrateurs correspondants 26, 28 et 30. Chaque intégrateur 26, 28 et 30 a un condensateur et une résistance couplés en parallèle et branchés en contre-réaction entre la sortie de l'intégrateur et son entrée inverseuse qui reçoit aussi le signal de sortie du circuit d'élévation au carré 24 correspondant. La valeur de la résistance est choisie de manière que, en l'absence de signal d'entrée, la charge du

condensateur associé s'écoule en un laps de temps constant de quelques secondes. Cela assure que le bruit et d'autres signaux indésirables issus des circuits d'élévation au carré 24 correspondants ne peuvent provoquer la production d'un signal de sortie d'amplitude significative par l'intégrateur associé.

Les sorties des intégrateurs 26, 28 et 30 représentatives des fonctions respectives:

$$I_{CA} = - \int (C-A)^2 dt$$
$$I_{AB} = - \int (A-B)^2 dt$$
$$I_{BC} = - \int (B-C)^2 dt$$

sont reliées à un circuit de contrôle indiqué de manière générale par 32. Une première partie de circuit de contrôle 32 comprend trois comparateurs 34, 36 et 38 et un amplificateur de sommation 40 ayant un gain G. L'entrée inverseuse de chaque comparateur 34, 36 et 38 est branchée pour recevoir l'un des signaux correspondants $I_{CA}$, $I_{AB}$ et $I_{BC}$, ces trois signaux étant aussi appliqués sur les entrées de l'amplificateur sommateur 40. Les sorties des quatre circuits 34 à 40 sont reliés aux bornes de sortie correspondantes 42 à 48. Le gain G de l'amplificateur sommateur 40 est fixé à une valeur un peu inférieure à la valeur donnée par la fonction $\frac{1}{3} \sin^2 15°$.

Une seconde partie du circuit de contrôle 32 comprend trois autres comparateurs 50, 52 et 54, branchés pour recevoir les signaux de sortie des intégrateurs 26, 28 et 30 de la façon suivante: le comparateur 50 reçoit le signal $I_{CA}$ sur son entrée non inverseuse et le signal $I_{BC}$ sur son entrée inverseuse; le comparateur 52 reçoit le signal $I_{AB}$ sur son entrée non inverseuse et le signal $I_{CA}$ sur son entrée inverseuse, et le comparateur 54 reçoit le signal $I_{BC}$ sur son entrée non inverseuse et le signal $I_{AB}$ sur son entrée inverseuse. La sortie de chacun de ces comparateurs est appliquée à l'une des trois entrées d'une porte NAND 56, 58 ou 60 correspondante.

En outre, la sortie du comparateur 50 est appliquée à travers un inverseur 62 sur une entrée de la porte 60, la sortie du comparateur 52 est appliquée à travers un inverseur 64 sur une entrée de la porte 56, et la sortie du comparateur 54 est appliquée à travers un inverseur 66 sur une entrée de la porte 58.

La troisième entrée de chacune des portes NAND 56, 58 et 60 est branchée pour recevoir le signal de sortie d'une porte ET 68 à trois entrées reliées respectivement à la sortie des comparateurs 34, 36 et 38. Les sorties des portes 56, 58 et 60 sont reliées aux bornes de sortie respectives 70, 72 et 74.

Pendant le fonctionnement normal, sans perturbations, de la ligne de puissance 10, l'effet combiné des filtres 16 et des résistances de fuite dans les intégrateurs 26, 28 et 30 empêche l'apparition de tout signal significatif à la sortie de ces intégrateurs. Par suite, les comparateurs 34, 36 et 38 fournissent des signaux logiques à haut niveau sur les bornes de sortie 42, 44 et 46, et les comparateurs 50, 52 et 54 – agissant par l'intermédiaire des inverseurs associés 62, 64 et 66 – provoquent la fourniture de signaux logiques à haut niveau par les portes 56, 58 et 60 sur les bornes de sortie 70, 72 et 74.

Dans le cas d'un défaut sur la ligne 10, les filtres 16 vont fournir des signaux de sortie indicatifs des courants transitoires associés passant dans les trois phases A, B et C aux amplificateurs différentiels 18, 20 et 22. Les amplificateurs vont alors produire des signaux indicatifs des différences entre les courants transitoires dans chaque paire de phases, les circuits 24 vont élever au carré les valeurs de ces différences et les intégrateurs 26, 28 et 30 intégrer les valeurs résultantes. Comme il est expliqué plus loin, on peut montrer que, si le défaut affecte seulement une des trois phases, le signal de sortie de l'intégrateur tiré des deux autres phases, c'est-à-dire des phases non en défaut, reste à zéro, tandis que les signaux de sortie des deux autres intégrateurs croissent notablement. Par conséquent, la sortie de l'amplificateur sommateur 40 augmente également, fournissant un signal de sortie sur la borne 48 indicatif de l'apparition d'un défaut, et fournissant aussi une tension de référence aux entrées non inverseuses des comparateurs 34, 36 et 38. Tenant compte de l'inversion de signe introduite par les intégrateurs 26, 28 et 30, le fait que le signal de sortie de l'intégrateur reste à zéro a donc pour effet que la sortie du comparateur associé tombe à zéro. Le signal logique à bas niveau consécutif sur la borne de sortie correspondante 42, 44 ou 46 indique quelle est celle des trois phases qui fait l'objet du défaut. Ce même signal agit aussi à travers la porte ET 68, pour maintenir les sorties des portes 56, 58 et 60 à leur niveau logique haut.

Si on suppose par exemple que le défaut électrique a affecté seulement la phase A de la ligne 10, les signaux de sortie des intégrateurs 26 et 28 prennent des valeurs négatives importantes, tandis que le signal de sortie de l'intégrateur 30 reste très voisin de zéro. Ainsi, la sortie de l'amplificateur sommateur 40 prend aussi une valeur négative importante, mais le gain G de l'amplificateur 40 est choisi pour que cette valeur soit plus faible en amplitude (c'est-à-dire plus positive) que les signaux de sortie des intégrateurs 26 et 28, de sorte que les comparateurs 34 et 36 continuent de fournir des signaux logiques à haut niveau sur les bornes de sortie 42 et 44. En revanche, le signal de sortie de l'amplificateur 40 est plus négatif que le signal de sortie nul de l'intégrateur 30, de sorte que le comparateur 38 commence à fournir un signal logique à bas niveau sur la borne de sortie 46, indiquant par là que le défaut affecte une seule phase, à savoir la phase A.

On peut aussi montrer que, dans le cas d'un défaut affectant deux phases, la sortie de l'intégrateur 26, 28 ou 30 associé à ces deux phases devient notablement plus élevée que les sorties des deux autres intégrateurs. Cependant, quoique les sorties de ces deux intégrateurs deviennent relativement basses, elles ne deviennent pas exactement égales à zéro. On peut montrer que, si le gain de l'amplificateur 40 est réglé à une valeur pas plus grande que la valeur indiquée précédemment (et en pratique un peu inférieure pour prévoir une marge de bruit réelle), les signaux de sortie des deux autres intégrateurs restent plus grands (c'est-à-dire moins négatifs) que la sortie de l'amplificateur 40, assurant par là que les bornes de sortie 42, 44 et 46 continuent à fournir des signaux logiques à haut niveau.

En revanche, les comparateurs 50, 52 et 54 et les inverseurs 62, 64 et 66 coopèrent maintenant pour ouvrir une des portes 56, 58 et 60 (qui ne sont plus bloquées maintenant par un signal logique à bas niveau de la porte ET 68) suivant le signal de sortie d'intégrateur $I_{CA}$, $I_{AB}$ ou $I_{BC}$ le plus grand en amplitude. Ainsi, la borne de sortie correspondante 70, 72 ou 74 fournit un signal de sortie logique à bas niveau indiquant que le défaut affecte deux phases et l'identité des deux phases concernées.

Par exemple, si le défaut affecte les phases A et B, la sortie de l'intégrateur 28 prend une valeur négative relativement grande, alors que les sorties des deux autres intégrateurs 26 et 30 prennent des valeurs négatives relativement plus faibles. Ainsi, comme décrit ci-dessus, tous les comparateurs 34, 36 et 38 continuent à fournir un signal logique à haut niveau. Le comparateur 52 fournit un signal logique à haut niveau indiquant que le signal de sortie $I_{AB}$ de l'intégrateur 28 est plus grand (c'est-à-dire moins négatif) que le signal de sortie $I_{CA}$ de l'intégrateur 26, et le comparateur 54 fournit un signal logique à bas niveau indiquant que le signal de sortie $I_{AB}$ est de même plus grand (c'est-à-dire moins négatif) que le signal de sortie $I_{BC}$. Ce dernier signal logique est inversé par l'inverseur 66 avec pour effet que la porte 58 reçoit des signaux logiques à haut niveau sur ses trois entrées et fournit donc un signal logique à bas niveau à sa sortie sur la borne de sortie 72. Cela indique que le défaut affecte deux phases et que les phases en défaut sont A et B. On peut voir que la porte 56 reçoit un signal logique à bas niveau de l'inverseur 64, et que la porte 60 reçoit un signal logique à bas niveau du comparateur 54, avec pour effet que ces deux portes continuent à fournir des signaux logiques à haut niveau à leur sortie sur les bornes de sortie correspondantes 70 et 74.

Dans le cas d'un système de protection de distance, il est nécessaire à la fois de distinguer des défauts monophasés (qui nécessitent au plus l'isolement de la seule phase concernée) de défauts concernant plusieurs phases, et de calculer la distance du défaut (pour permettre sa localisation par rapport à une section protégée du réseau et ainsi déterminer la nécessité d'un isolement dans cette section). A cet égard, les signaux sur les bornes de sortie 42, 44, 46, 70, 72 et 74 fournissent, dans le cas d'un défaut, une indication préliminaire commode sur la ou les phases qui peuvent être le plus avantageusement intéressées dans un calcul ultérieur de la distance et de la nature du défaut. Ainsi, des calculs inutiles concernant des signaux de phases ou de combinaisons de phases qui ne fournissent en fait aucune information utile sur un défaut particulier peuvent être évités.

Si l'appareil doit être utilisé dans un système de protection directionnelle (dans lequel la localisation d'un défaut est établie par comparaison de la direction détectée du défaut en des points distants du réseau plutôt que par le calcul de la distance), les bornes de sortie 70, 72 et 74 et les circuits associés 50 à 68 peuvent être supprimés. Dans ce cas, la présence de signaux de sortie à la fois sur la borne de sortie 48 et sur l'une des bornes de sortie 42, 44 et 46 indique un défaut monophasé, alors qu'un signal sur la borne 48 seule indique un autre genre de défaut concernant plus d'une phase. La détermination directionnelle, qui peut être réalisée indépendamment du genre de défaut, peut alors être utilisée en liaison avec ces signaux pour décider si la phase individuelle correspondante ou toutes les trois ont besoin d'être isolées.

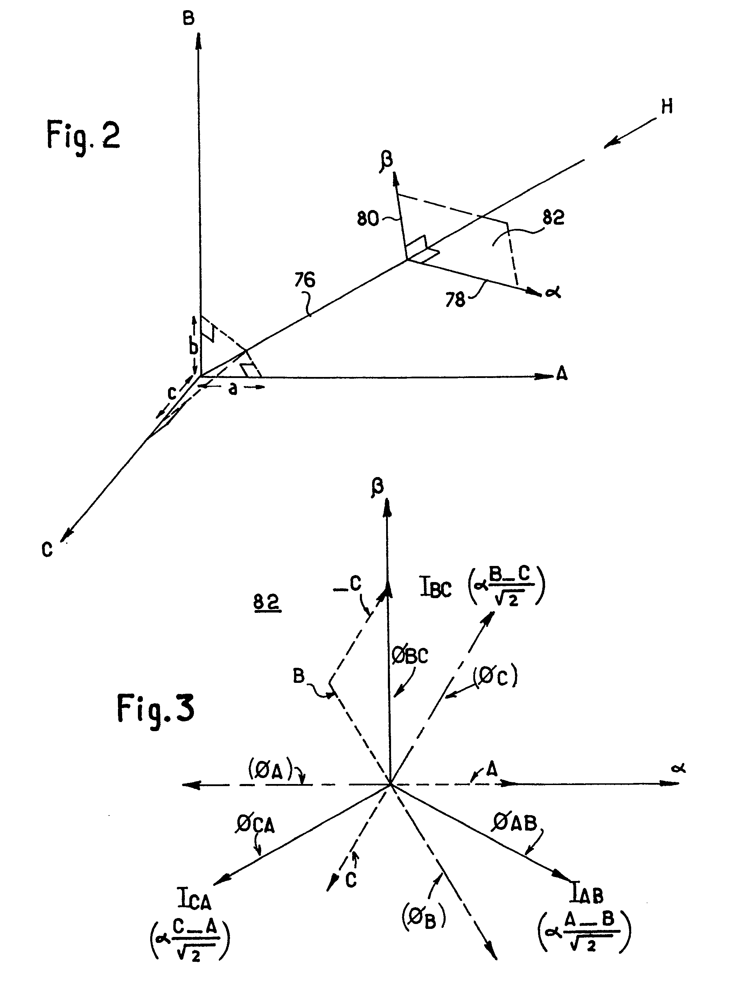

Les principes sur lesquels repose le fonctionnement de l'appareil vont maintenant être exposés en se référant aux fig. 2 et 3.

Sur la fig. 2, les signaux transitoires fournis par les trois filtres 16A, 16B et 16C sont représentés par trois axes de vecteurs mutuellement orthogonaux A, B et C (il est entendu que l'axe C doit en réalité être considéré comme dirigé vers le haut, hors de et perpendiculairement au plan du dessin). Une ligne 76 représente la direction du vecteur homopolaire pour laquelle les composantes a, b et c du vecteur sont égales. Deux autres lignes 78 et 80 représentent des axes orthogonaux $\alpha$ et $\beta$ d'un plan 82 qui est perpendiculaire à la direction 76 du vecteur homopolaire.

La discussion qui suit concerne des vecteurs se trouvant dans ce plan 82 (dont les axes sont parfois appelés composantes et $\beta$ de Clarke), qui est représenté vu directement de dessus à la fig. 3 (c'est-à-dire suivant la direction vectorielle 76, comme indiqué par la flèche H).

Sur la fig. 3, trois lignes en pointillé A, B et C représentent les projections sur le plan 82 des axes A, B et C de la fig. 2. On peut voir que l'axe $\alpha$ coïncide avec la projection de l'axe A sur ce plan. On peut montrer que, au moins pour la durée de quelques périodes de la forme d'onde d'alimentation suivant un défaut, il n'y a aucun couplage significatif entre les composantes de vecteurs suivant les axes $\alpha$ et $\beta$ respectivement. De plus, tout vecteur résultant (dans l'espace tridimensionnel de la fig. 2) formé en combinant les trois vecteurs de signaux transitoires suivant les axes A, B et C peut lui-même être décomposé en deux autres composantes: une composante étant la projection de la résultante sur la direction 76 du vecteur homopolaire et une autre composante étant la projection de la résultante sur le plan orthogonal à cette direction 76, c'est-à-dire sur le plan $\beta$ 82. Cette dernière composante dans le plan 82 aura une direction qui est indicative du vecteur de signal transitoire A, B ou C qui a contribué au vecteur résultant global à partir duquel la composante est dérivée par projection sur le plan 82. Ainsi, un signal transitoire apparaissant seulement sur l'axe de la phase A de la fig. 2 donne naissance à une composante dans le plan $\alpha$-$\beta$ 82 seulement suivant l'axe de la fig. 3, comme indiqué par ($\emptyset A$). De même, des signaux transitoires apparaissant seulement sur les axes de la phase B ou de la phase C de la fig. 2 donnent naissance à des composantes respectives seulement suivant les projections de ces axes, telles qu'indiquées par (ØB) et (ØC) à la fig. 3.

La différence entre des signaux transitoires concernant par exemple les phases B et C (dus à un défaut affectant seulement ces deux phases) a une composante dans le plan 82 qui, par soustraction vectorielle, est suivant l'axe $\beta$ de la fig. 3, comme indiqué par ØBC. Elle est orthogonale à la composante (ØA) concernant la seule phase A. De même, les différences entre les signaux transitoires concernant seulement les phases C et A, ou A et B, ont des composantes respectives ØCA et ØCB dans le plan 82, qui sont respectivement orthogonales aux composantes (ØB) et (ØC).

Les signaux de sortie des intégrateurs 26, 28 et 30 de la fig. 1 sont représentatifs de la somme des carrés des trois paires de différences entre les signaux transitoires, de sorte que ces signaux de sortie $I_{CA}$, $I_{AB}$ et $I_{BC}$ sont indicatifs de l'amplitude des trois composantes ØCA, ØAB et ØBC de la fig. 3. Ainsi, comme indiqué plus haut, si un défaut concerne seulement la phase A par exemple, donnant par là naissance à seulement un signal transitoire suivant l'axe de phase A de la fig. 2 et à une composante (ØA) suivant l'axe de la fig. 3, la composante ØBC (représentée par le signal $I_{BC}$), étant orthogonale à cet axe, n'est pas affectée et reste égale à zéro. En revanche, les composantes ØCA et ØAB, n'étant pas orthogonales à l'axe , sont affectées et deviennent non nulles. Ainsi, la valeur zéro continuelle d'une seule des composantes ØBC, ØCA et ØAB (c'est-à-dire des signaux correspondants $I_{BC}$, $I_{CA}$ et $I_{AB}$) indique un défaut monophasé, et l'identité du signal concerné, dans le cas $I_{BC}$, indique que la phase orthogonale A est affectée. Si un défaut concerne deux phases, par exemple les phases B et C, le signal correspondant $I_{BC}$ devient grand, alors que les deux autres signaux $I_{CA}$ et $I_{AB}$ deviennent faibles, quoique non nuls. L'identité du signal le plus grand, $I_{BC}$, indique alors directement les phases B et C affectées.

Dans le cas d'un défaut monophasé, la phase en défaut sera isolée, faisant ainsi apparaître un autre signal transitoire sur la ligne 10. Cependant, ce second signal transitoire se traduit manifestement par une composante dans le plan 82 de même direction que le signal transitoire originel provoqué par le défaut. Ainsi, l'appareil ne fournit aucune indication inutile à la suite de cet isolement.

Le circuit de la fig. 1 peut bien entendu être modifié de nombreuses façons. Ainsi, au lieu de détecter le courant s'écoulant dans les phases A, B et C, l'appareil peut détecter la tension, ou une combinaison linéaire de la tension et du courant, pour chaque phase. Les filtres 16 peuvent être placés derrière les amplificateurs 18 à 22 au lieu de l'être devant. Aussi, les paires de signaux particuliers C-A, A-B, B-C sont seulement des exemples: il y a évidemment bien d'autres manières de combiner les signaux des trois phases A, B et C pour déterminer les amplitudes des composantes de vecteurs se trouvant dans le plan 82 illustré à la fig. 3.

Il est cependant nécessaire qu'il s'agisse de combinaisons linéaires, et que les coefficients de chaque combinaison linéaire aient une somme nulle, afin que la composante homopolaire soit nulle. On pourrait par exemple utiliser des combinaisons du type 2A-B-C. De plus, au lieu de former le carré de ces combinaisons, on pourrait former le produit de deux combinaisons linéaires répondant à la condition ci-dessus. Mais l'utilisation des paires C-A, A-B, B-C est la solution préférée, étant donné sa grande simplicité de mise en œuvre.

## Revendications

1. Procédé pour identifier la phase en défaut dans un réseau de distribution électrique à N phases, caractérisé par le fait qu'il comprend les opérations suivantes:

— on produit, pour chacune des N phases, un premier signal représentatif des variations transitoires d'un paramètre électrique associé à la phase considérée, ou d'une combinaison linéaire de plusieurs de ces paramètres;

— on élabore un ensemble de N seconds signaux, chaque second signal étant obtenu par le produit de deux combinaisons linéaires d'au moins N−1 signaux pris parmi les premiers signaux, la somme des coefficients étant nulle pour chaque combinaison linéaire, chaque second signal étant relatif seulement à une phase;

— on intègre par rapport au temps chacun des seconds signaux pour obtenir un ensemble de N troisièmes signaux relatifs chacun seulement à une phase;

— on élabore un quatrième signal par une combinaison des N troisièmes signaux, le poids attribué à chacun des N troisièmes signaux dans la combinaison étant le même, ledit quatrième signal étant ainsi indépendant des phases auxquelles sont associés les troisièmes signaux;

— on compare le quatrième signal à chacun des troisièmes signaux, et

— on identifie la phase en défaut suivant les résultats des comparaisons obtenus.

2. Procédé selon la revendication 1, caractérisé par le fait que le quatrième signal est obtenu par la somme des N troisièmes signaux.

3. Procédé selon l'une des revendications 1 ou 2, caractérisé par le fait que, dans le cas d'un réseau triphasé, chaque second signal relatif à une phase est obtenu par le carré de la différence entre la paire de premiers signaux relatifs aux deux autres phases.

4. Procédé selon la revendication 3, caractérisé par le fait que, pour pouvoir identifier deux phases simultanément en défaut, on élabore en outre un ensemble de trois cinquièmes signaux en formant la différence entre chaque paire de troisièmes signaux, et on forme trois signaux logiques, relatifs chacun à une paire de phases, en combinant deux à deux les cinquièmes signaux, le niveau de chacun desdits signaux logiques étant indicatif de la présence d'un défaut sur la paire de phases correspondante.

5. Procédé selon l'une des revendications 1 à 4, caractérisé par le fait que ledit paramètre électrique est l'intensité du courant circulant dans chaque phase.

**Patentansprüche**

1. Verfahren zum Identifizieren einer fehlerhaften Phase in einem N-phasigen Verteilungsnetz, dadurch gekennzeichnet, dass es folgende Massnahmen enthält:

— für jede N-Phasen wird ein erstes Signal erzeugt, welches vorübergehende Änderungen eines elektrischen Parameters darstellt, der der betrachteten Phase zugeordnet ist, oder eine lineare Kombination mehrerer dieser Parameter darstellt;

— eine Gruppe von N zweiten Signalen wird erzeugt, wobei jedes zweite Signal erhalten wird, indem das Produkt von zwei linearen Kombinationen aus wenigstens N−1-Signalen unter den ersten Signalen gebildet wird, wobei die Summe des Koeffizienten für jede lineare Kombination gleich Null ist und wobei jedes zweite Signal nur eine Phase betrifft;

— jedes der zweiten Signale wird über die Zeit integriert, um eine Gruppe von N dritten Signalen zu erhalten, die jeweils nur eine Phase betreffen;

— ein viertes Signal wird durch eine Kombination der N dritten Signale gebildet, wobei das jedem der N dritten Signale beigemessene Gewicht in der Kombination dasselbe ist und wobei das vierte Signal somit unabhängig von den Phasen ist, denen die dritten Signale zugeordnet sind;

— das vierte Signal wird mit jedem der dritten Signale verglichen, und

— die fehlerhafte Phase wird aus den erhaltenen Vergleichsergebnissen bestimmt.

2. Verfahren nach Anspruch 1, dadurch gekennzeichnet, dass das vierte Signal durch Summenbildung der N dritten Signale erhalten wird.

3. Verfahren nach einem der beiden Ansprüche 1 oder 2, dadurch gekennzeichnet, dass für den Fall eines dreiphasigen Netzes jedes zweite, eine Phase betreffende Signal durch das Quadrat der Differenz zwischen den beiden ersten Signalen, welche die beiden anderen Phasen betreffen, erhalten wird.

4. Verfahren nach Anspruch 3, dadurch gekennzeichnet, dass zum Identifizieren von zwei gleichzeitig fehlerhaften Phasen ferner eine Gruppe von drei fünften Signalen gebildet wird, indem die Differenz zwischen jedem Signalpaar der dritten Signale gebildet wird und drei Logiksignale, die jeweils ein Phasenpaar betreffen, gebildet werden, indem die fünften Signale zwei zu zwei miteinander kombiniert werden, wobei der Pegel jedes dieser Logiksignale eine Anzeigegrösse für das Vorhandensein eines Fehlers an dem entsprechenden Phasenpaar bildet.

5. Verfahren nach einem der Ansprüche 1 bis 4, dadurch gekennzeichnet, dass der genannte elektrische Parameter die Stärke des in jeder Phase fliessenden Stromes ist.

**Claims**

1. A method for identifying which of the phases in a N-phase electric-power transmission network has experienced for a fault, comprising the steps of:

— producing for each a first signal representative of the transient variations of an electrical parameter of the respective phase, or of a linear combination of at least two of said parameters;

— generating a set of N second signals, each second signal being obtained as the product of two linear combinations of at least N−1 signals selected among said first signals, the sum of all coefficients for each linear combination being nil, each of said second signals being related to only one phase;

— integrating with respect to time each of said second signals to produce a set of N third signals, each relating to only one phase;

— generating a fourth signal by combining the N third signals, the weight given to each of said N third signals in the combination being the same for these signals, whereby said fourth signal is independant of the phases with which the third signals are associated;

— comparing said fourth signal with each of said third signals to produce comparison signals; and

— identifying the faulty phase in accordance with the comparison signals thus produced.

2. A method according to claim 1, characterized in that said fourth signal is generated as the sum of said N third signals.

3. A method according to claim 1 or 2, characterized in that, in a three-phase transmission network, each second signal related to a given phase is generated as the square of the difference between the pair of first signals related to the other two phases.

4. A method according to claim 3, characterized in that, for identifying two phases which simultaneously have experienced a fault, it further comprises the steps of generating a set of three fifth signals by forming the difference between each pair of said third signals, and producing three logical signals each related to a pair of phases by combining in pairs the fifth signals thus generated, the state of each of said logical signals being indicative of a fault in the respective pair of phases.

5. A method according to any one of the claims 1 to 4, characterized in that said electrical parameter is the current in the respective phase.

Fig.1

0 038 259

Fig. 2

Fig. 3